# EUROPÄISCHE PATENTSCHRIFT

(11) **EP 1 316 116 B1**
(45) Veröffentlichungstag und Bekanntmachung des Hinweises auf die Patenterteilung: **22.07.2009**
(21) Anmeldenummer: 01971681.0
(22) Anmeldetag: 29.08.2001
(51) Int. Cl.: H01L 51/05, H01L 51/40

(54) **VERFAHREN ZUR STRUKTURIERUNG EINES ORGANISCHEN FELDEFFEKTTRANSISTORS**
METHOD FOR STRUCTURING AN ORGANIC FIELD EFFECT TRANSISTOR
PROCEDE POUR STRUCTURER UN TRANSISTOR ORGANIQUE A EFFET DE CHAMP

(30) Priorität: 01.09.2000 DE 10043204
(43) Veröffentlichungstag der Anmeldung: 04.06.2003
(73) Patentinhaber: PolyIC GmbH & Co. KG, 90763 Fürth (DE)
(72) Erfinder: CLEMENS, Wolfgang, 90617 Puschendorf (DE); BERNDS, Adolf, 91083 Baiersdorf (DE); ROST, Henning, 91056 Erlangen (DE); FIX, Walter, 90427 Nürnberg (DE)
(74) Vertreter: LOUIS, PÖHLAU, LOHRENTZ
(86) Internationale Anmeldenummer: PCT/DE2001/003318
(87) Internationale Veröffentlichungsnummer: WO 2002/019443

(56) Entgegenhaltungen:
- EP-A- 0 852 403
- DE-A- 19 851 703
- GB-A- 1 243 076
- JP-A- 4 069 991
- US-A- 6 087 196
- ROGERS J A ET AL: "PRINTING PROCESS SUITABLE FOR REEL-TO-REEL PRODUCTION OF HIGH-PERFORMANCE ORGANIC TRANSISTORS AND CIRCUITS" ADVANCED MATERIALS, VCH VERLAGSGESELLSCHAFT, WEINHEIM, DE, Bd. 11, Nr. 9, 5. Juli 1999 (1999-07-05), Seiten 741-745, XP000851834 ISSN: 0935-9648
- ROGERS J A ET AL: "LOW-VOLTAGE 0.1 MUM ORGANIC TRANSISTORS AND COMPLEMENTARY INVERTER CIRCUITS FABRICATED WITH A LOW-COST FORM OF NEAR-FIELD PHOTOLITHOGRAPHY" APPLIED PHYSICS LETTERS, AMERICAN INSTITUTE OF PHYSICS. NEW YORK, US, Bd. 75, Nr. 7, 16. August 1999 (1999-08-16), Seiten 1010-1012, XP000827671 ISSN: 0003-6951

## Beschreibung

Die Erfindung betrifft einen Organischen Feld-Effekt-Transistor, ein Verfahren zur Strukturierung eines OFETs und eine integrierte Schaltung mit verbesserter Strukturierung der Funktionspolymerschichten.

Organische integrierte Schaltkreise (integrated plastic circuits) auf der Basis von OFETs werden für mikroelektronische Massenanwendungen und Wegwerf-Produkte wie Identifikations- und Produkt-"tags" gebraucht. Ein "tag" ist z.B. ein elektronischer Streifencode, wie er auf Waren angebracht wird oder auf Koffern. OFETs haben ein weites Einsatzgebiet als RFIDtags: radio frequency identification - tags, die nicht nur auf der Oberfläche angeordnet sein müssen. Bei OFETs für diese Anwendungen kann auf das exzellente Betriebsverhalten der Silizium-Technologie verzichtet werden, aber dafür sollten niedrige Herstellungkosten und mechanische Flexibilität gewährleistet sein. Die Bauteile wie z.B. elektronische Strich-Kodierungen, sind typischerweise Einwegeprodukte und sind wirtschaftlich nur interessant, wenn sie in preiswerten Prozessen hergestellt werden.

Bisher wird, wegen der Herstellungskosten, nur die Leiterschicht des OFETs strukturiert. Die Strukturierung kann nur über einen zweistufigen Prozess ("Lithographiemethode" vgl dazu Applied Physics Letters 73(1),1998, S.108.110 und Mol.Cryst.Liq. Cryst. 189,1990, S.221-225) mit zunächst vollflächiger Beschichtung und darauffolgender Strukturierung, die zudem materialspezifisch ist, bewerkstelligt werden. Mit "Materialspezifität" ist gemeint, dass der beschriebene Prozess mit den genannten photochemischen Komponenten einzig an dem leitfähigen organischen Material Polyanilin funktioniert. Ein anderes leitfähiges organisches Material, z.B. Polypyrrol, läßt sich so nicht ohne weiteres auf diese Art strukturieren.

Die fehlende Strukturierung der anderen Schichten, wie zumindest die der halbleitenden und der isolierenden Schicht aus Funktionspolymeren (die polymer oder oligomer vorliegen können), führt zu einer deutlichen Leistungssenkung der erhaltenen OFETs, darauf wird aber trotzdem aus Kostengründen verzichtet. Die strukturierte Schicht kann mit anderen bekannten Verfahren (wie z.B. Drucken) nur so strukturiert werden, dass die Länge 1, die den Abstand zwischen Source und Drain Elektrode bezeichnet und damit ein Maß für die Leistungsdichte des OFETs darstellt zumindest 30 bis 50 µm beträgt. Angestrebt werden aber Längen 1 von unter 10 µm, so dass außer der aufwendigen Lithographiemethode momentan keine Strukturierungsmethode sinnvoll erscheint.

Aufgabe der Erfindung ist daher ein kostengünstiges und massenfertigungstaugliches Verfahren zur Strukturierung von OFETs mit hoher Auflösung zur Verfügung zu stellen. Weiterhin ist Aufgabe der Erfindung, einen leistungsstärkeren, weil mit mehr strukturierten Schichten ausgestatteten sowie einen kompakteren OFET zu schaffen, der mit einem geringeren Abstand 1 herstellbar ist.

Gegenstand der Erfindung ist ein Verfahren zur Strukturierung eines organischen Feldeffekttransistors (OFET) durch Einrakeln von zumindest einem Funktionspolymer (7) in Vertiefungen (8) einer Formschicht (1), die aus organischem Material ist und auf ein Substrat (2) oder eine untere Schicht (2) aufgebracht ist, folgende Arbeitsschritte umfassend:
a) auf einem Substrat (2) oder einer unteren Schicht (2) wird eine Formschicht (1) für eine Negativform aufgebracht,
b) diese Formschicht (1) erhält Vertiefungen (8), die den Negativen der späteren Strukturen entsprechen und
c) in diese Vertiefungen (8) wird dann das Funktionspolymer (7) hinein gerakelt.

Als Negativ-Form wird eine strukturierte Schicht oder ein Teil einer strukturierten Schicht bezeichnet, die Vertiefungen enthält, in die das Funktionspolymer, das z.B. eine Elektrode eines OFETs oder eine Halbleiter- oder eine Isolatorschicht bildet, durch Rakeln eingefüllt wird.

Die Länge 1 die den Abstand zwischen Source und Drain Elektrode beschreibt, kann dabei bis zur Grössenordnung von λ (Wellenlänge) des eingestrahlten Lichts, wenn die Negativ-Form durch Bestrahlung strukturiert wird verkleinert werden. Bevorzugt ist ein OFET mit einer Länge 1 von kleiner 20 µm, insbesondere von kleiner 10 µm und ganz bevorzugt von 2 bis 5 µm oder kleiner.

Das Verfahren umfasst folgende Arbeitsschritte:
a) auf einem Substrat oder einer unteren Schicht wird eine, ggf. vollflächige Formschicht, die nicht auf den Bereich, der strukturiert werden soll beschränkt sein muss, aufgebracht. Diese Formschicht ist nicht das Funktionspolymer(also halbleitende, leitende oder isolierende Schicht), sondern ein anderes organisches Material, das als Form oder Klischee für die leitende organische Elektrodenschicht dient. Dieses andere organische Material sollte isolierende Eigenschaften haben.
b) die Formschicht erhält z.B. durch Belichten über eine Maske Vertiefungen, die den Strukturen entsprechen.
c) in diese Vertiefungen wird dann das Funktionspolymer flüssig, als Lösung und/oder als Schmelze hineingerakelt.

Die Negativ-Form der Struktur auf der Formschicht kann durch Belichten einer Photolackschicht auf dem Substrat oder einer unteren Schicht erzeugt werden. Das Material der Negativ-Form kann ein Photolack sein, der nach Belichten über eine Maske wie z.B. Schattenmaske oder eine andere bereits bechriebene Strukturierungsmethode und nachfolgendes Entwickeln Vertiefungen besitzt.

Dafür geeignete Lacke sind allesamt kommerziell erhältlich und die Methoden, sie z.B. durch Belichten zu strukturieren, sind literaturbekannt.

Der Vorteil der Rakel-Methode besteht darin, dass die schwierige Strukturierung von Funktionspolymeren durch die eingefahrene und bewährte Photolackmethode bewältigt wird. Dadurch kann auf einen reichen technischen Hntergrund zurückgegriffen werden und es können extrem feine Strukturen erzielt werden. Die Rakel-Methode ist zudem nicht materialspezifisch. Mit der Rakelmethode kann vielmehr Polyanilin, aber auch jedes andere leitfähige organische Material, z.B. Polypyrrol, zur Herstellung von Elektroden eingesetzt werden. Ebenso kann damit jedes andere organsiche Material wie z.B. Polythiophen als Halbleiter und/oder Polyvinylphenol als Isolator strukturiert werden, also der gesamte OFET.

Man kann im Mehrschichtaufbau eines OFETs eine oder mehrere Schichten mit der Rakel-Methode herstellen. Bei mehreren Schichten wird die Photolacktechnik zur Bildung der Negativ-Form bevorzugt, weil z.B. das Imprintverfahren die Formschicht nicht über die ganze Schichtdicke durchstrukturiert, sondern in den Vertiefungen einen bestimmten Boden stecken lässt, der den elektrischen Kontakt zu der darunter liegenden Schicht verhindert. Für die erste Schicht, z.B. Source-Drain-Elektroden, spielt das keine Rolle, aber für alle weiteren Schichten.

Nach einer Ausführungsform des Verfahrens wird die Negativ-Form nach erfolgter Aushärtung des Funktionspolymers entfernt, so dass ein eventuell durch Verdunstung des Lösungsmittels oder Schrumpfung entstandener Höhenunterschied zwischen Funktionspolymer und Negativ-Form vermindert wird.

Ein anderer Ansatz, einen gegebenenfalls entstandenen Höhenunterschied zwischen Negativ-Form und Funktionspolymer zu vermeiden, liegt in der Wiederholung des Einrakelvorgangs, wodurch das Volumen der Negaitv-Form einfach weiter aufgefüllt wird.

In der Regel kann man die Funktionspolymere weitgehend in ihrer optimalen Konsistenz belassen. So besitzt z.B. Polyanilin als leitfähiges organisches Material bei optimaler Leitfähigkeit eine bestimmte Viskosität. Soll Polyanilin gedruckt werden, so muss seine Viskosität auf einen der Druckmethode angepassten Wert eingestellt werden. Das bedeutet meistens Einbußen der Leitfähigkeit. Für das Rakeln ist die Viskositätsspanne ungleich größer als für das Drucken, so dass in aller Regel keine Viskositätsänderungen am organischen Material vorgenommen werden müssen.

Schließlich ist ein Vorteil der Rakelmethode die Fähigkeit zu dicken Schichten. So ist z.B. die Leitfähigkeit von 1µm dicken Polmerelektroden effektiv höher als bei üblicherweise 0.2µm Schichtdicke. Ein OFET mit einer Schichtdicke im Bereich von bis zu 1µm, insbesondere im Bereich von 0,3 bis 0,7 µm ist deshalb vorteilhaft.

Nach einer bevorzugten Ausführungsform des Verfahrens wird es kontinuierlich betrieben, das heißt ein Band mit der Formschicht wird nacheinander an verschiedenen Stationen vorbeigeführt wo zuerst über z.B. Belichtung mit einer Maske Vertiefungen in der Formschicht gebildet werden, die dann im weiteren Verlauf zumindest einmal mit Funktionspolymer über eine Rakelstation gefüllt werden.

Als "Funktionspolymer" wird hier jedes organische, metallorganische und/oder anorganische Material bezeichnet, das funktionell am Aufbau eines OFET und/oder einer integrierten Schaltung aus mehreren OFETs beteiligt ist. Dazu zählen beispielhaft die leitende Komponente (z.B. Polyanilin), das eine Elektrode bildet, die halbleitende Komponente, die die Schicht zwischen den Elektroden bildet und die isolierende Komponente. Es sei ausdrücklich darauf hingewiesen, dass die bezeichnung "Funktionspolymer" demnach auch nicht polymere Komponenten, wie z.B. oligomere Verbindungen, umfasst.

Als "organisch" wird hier kurz alles, was "auf organischem Material basiert" bezeichnet, wobei der Begriff "organisches Material" alle Arten von organischen, metallorganischen und/oder anorganischen Kunststoffen, die im Englischen z.B. mit "plastics" bezeichnet werden, umfasst. Es handelt sich um alle Arten von Stoffen mit Ausnahme der klassischen Halbleiter (Germanium, Silizium) und der typischen metallischen Leiter. Eine Beschränkung im dogmatischen Sinn auf organisches Material als Kohlenstoff-enthaltendes Material ist demnach nicht vorgesehen, vielmehr ist auch an den breiten Einsatz von z.B. Siliconen gedacht. Weiterhin soll der Term keiner Beschränkung auf polymere oder oligomere Materialien unterliegen, sondern es ist druchaus auch der Einsatz von "small molecules" denkbar.

Als "untere Schicht" wird hier jede Schicht eines OFETs bezeichnet, auf die eine zu strukturierende Schicht aufgebracht wird. Die Formschicht aus dem Formpolymer schließt an die "untere Schicht" oder das Substrat an. Das Formpolymer wird hier durch die Bezeichnung "polymer" auch nicht auf einen polymeren Aggregatszustand festgelegt, vielmehr kann es sich bei dieser Substanz auch um alle praktisch einsetzbaren Kunststoffe zur Ausbildung einer Negativ-Form handeln.

Im folgenden wird eine Ausführungsform des Verfahrens noch anhand von schematischen Figuren näher erläutert.

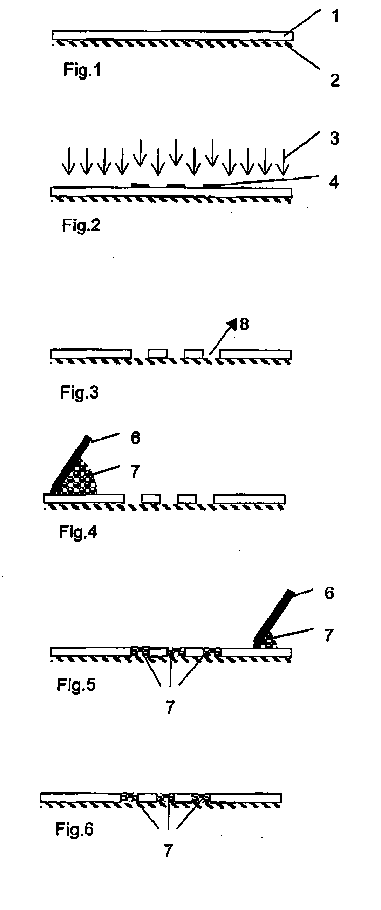

Figur 1 zeigt das Substrat oder eine untere Schicht 2 auf die die Formschicht der Negativ-Form 1, beispielsweise aus einem Formpolymer wie einem Photolack, vollflächig aufgebracht ist. Die Formschicht 1 wird, wie in Figur 2 gezeigt, über eine Schattenmaske 4 mit, beispielsweise UV-Strahlung 3, belichtet. Dadurch entstehen Vertiefungen 8 in der Formschicht 1, wie sie in Figur 3 gezeigt sind. In diese Vertiefungen wird dann das Funktionspolymer 7 mit einem Rakel 6 hineingerakelt (Figuren 4 und 5). In Figur 6 erkennt man, wie im fertigen OFET das Funktionspolymer 7 die Vertiefungen 8 der Formschicht 1 ausfüllt.

## Patentansprüche

1. Verfahren zur Strukturierung eines organischen Feldeffekttransistors (OFET) durch Einrakeln von zumindest einem Funktionspolymer (7) in Vertiefungen (8) einer Formschicht (1), die aus organischem Material ist und auf ein Substrat (2) oder eine untere Schicht (2) aufgebracht ist, folgende Arbeitsschritte umfassen:
a) auf einem Substrat (2) oder einer unteren Schicht (2) wird eine Formschicht (1) für eine Negativform aufgebracht,
b) diese Formschicht (1) erhält Vertiefungen (8), die den Negativen der späteren Strukturen entsprechen und
c) in diese Vertiefungen (8) wird dann das Funktionspolymer (7) hinein gerakelt.

2. Verfahren nach Anspruch 1, bei dem die Formschicht (1) nach der Strukturierung entfernt wird.

3. Verfahren nach einem der Ansprüche 1 oder 2, bei dem zumindest zweimal das Funktionspolymer (7) in die Vertiefungen (8) der Formschicht (1) eingerakelt wird.

4. Verfahren nach einem der Ansprüche 1 bis 3, bei dem die Vertiefungen (8) in der Formschicht (1) durch Bestrahlung mit einer Maske erzeugt werden.

5. Verfahren nach einem der Ansprüche 1 bis 4, das als kontinuierliches Verfahren mit einem durchlaufenden Band durchgeführt wird.

## Claims

1. Method for structuring an organic field effect transistor (OFET) by scraping at least one functional polymer (7) into recesses (8) of a mould layer (1) which is made of organic material and is applied to a substrate (2) or a lower layer (2), comprising the following operations:
a) a mould layer (1) for a negative mould is applied to a substrate (2) or a lower layer (2),
b) this mould layer (1) acquires recesses (8) which correspond to the negatives of the subsequent structures and
c) the functional polymer (7) is then scraped into these recesses (8).

2. Method according to Claim 1, in which the mould layer (1) is removed after the structuring.

3. Method according to either of Claims 1 and 2, in which the functional polymer (7) is scraped at least twice into the recesses (8) of the mould layer (1).

4. Method according to any of Claims 1 to 3, in which the recesses (8) in the mould layer (1) are produced by irradiation using a mask.

5. Method according to any of Claims 1 to 4, which is carried out as a continuous method using a continuously moving belt.

## Revendications

1. Procédé de structuration d'un transistor organique à effet de champ (OFET) par introduction au racle d'au moins un polymère fonctionnel (7) dans des renfoncements (8) d'une couche moulée (1) qui est en un matériau organique et qui est appliquée sur un substrat (2) ou sur une couche inférieure (2), comprenant les étapes de travail suivantes :
a) sur un substrat (2) ou sur une couche inférieure (2) est appliquée une couche moulée (1) pour une forme en négatif,
b) cette couche moulée (1) reçoit des renfoncements (8) qui correspondent aux négatifs des futures structures et
c) le polymère fonctionnel (7) est alors introduit au racle dans ces renfoncements (8),

2. Procédé selon la revendication 1, dans lequel la couche moulée (1) est retirée après la structuration.

3. Procédé selon l'une quelconque des revendications 1 ou 2, dans lequel le polymère fonctionnel (7) est introduit au moins deux fois au racle dans les renfoncements (8) de la couche moulée (1).

4. Procédé selon l'une quelconque des revendications 1 à 3, dans lequel les renfoncements (8) dans la couche moulée (1) sont produits avec un masque par exposition à un rayonnement.

5. Procédé selon l'une quelconque des revendications 1 à 4, qui est exécuté comme procédé continu avec une bande défilante.
